# EUROPEAN PATENT APPLICATION

(11) **EP 4 770 295 A1**
(43) Date of publication of application: **01.07.2026**
(21) Application number: 25220145.4
(22) Date of filing: 02.12.2025
(51) Int. Cl.: H05K 7/20

(54) **FLUID REPLENISHING SYSTEM, FLUID REPLENISHING AUTONOMOUS MOBILE VEHICLE, AND FLUID REPLENISHING METHOD**

(30) Priority: 19.12.2024 US 202463736219 P
(71) Applicant: Auras Technology Co., Ltd., New Taipei City 242 (TW)
(72) Inventor: ZHANG, Kaitlyn, 242 New Taipei City (TW); HO, Hsuan-Yu, 242 New Taipei City (TW); YE, Tian-Li, 242 New Taipei City (TW); CHEN, Chien-Yu, 242 New Taipei City (TW)
(74) Representative: Berggren Oy

(57) **Abstract**

A fluid replenishing system, a fluid replenishing autonomous mobile vehicle, and a fluid replenishing method are provided, and the fluid replenishing autonomous mobile vehicle includes a working chassis, a moving mechanism, a first fluid tank, a second fluid tank, a robotic arm, a first connector assembly, a second connector assembly, a first pipeline set and a second pipeline set. The moving mechanism, the first fluid tank, the second fluid tank and the robotic arm are arranged on the working chassis. The first connector assembly is arranged on the robotic arm. The first pipeline set is connected to the first fluid tank and the first connector assembly. The second pipeline set is connected to the second fluid tank and the second connector assembly.

## Description

### BACKGROUND

### Field of Invention

The present disclosure relates to a fluid replenishing system, a fluid replenishing autonomous mobile vehicle, and a fluid replenishing method.

### Description of Related Art

Generally, a fluid replenishing autonomous mobile device is one type of Automated Guided Vehicles (AGV), typically referring to an equipment with automated movement capability (e.g., Autonomous Mobile Robot , AMR) and able to perform coolant replenishment operations in factories, servers, or production areas. For example, the fluid replenishing autonomous mobile device can automatically move to a server equipment, and exchange coolant in any cooling distribution unit (CDU) on the server equipment.

However, since the cooling distribution units with different specification types may have inlet and outlet ends which are located at different locations, the fluid outlet and inlet connectors of the fluid replenishing autonomous mobile device cannot be compatible with the inlet and outlet ends of all types of cooling distribution units, thus narrowing the service range of the fluid replenishing autonomous mobile device and flexibility in cooperating with various server equipment.

Thus, how to develop a solution for improving the aforementioned deficiencies and inconveniences is a crucial and urgent task for relevant issues.

### SUMMARY

One objective of the present disclosure is to provide a fluid replenishing system, a fluid replenishing autonomous mobile vehicle, and a fluid replenishing method to solve the difficulties mentioned in the related art.

An embodiment of the present disclosure is to provide a fluid replenishing autonomous mobile vehicle. The fluid replenishing autonomous mobile vehicle includes a working chassis, a moving mechanism, a first fluid tank, a second fluid tank, a robotic arm, a first connector assembly, a second connector assembly, a first pipeline set and a second pipeline set. The moving mechanism is located on the working chassis for moving to a designated position. The first fluid tank is located on the working chassis for containing replenishing fluid. The second fluid tank is located on the working chassis for containing recovered fluid. The robotic arm is located on the working chassis. The first connector assembly is located on the robotic arm for mating with an inlet end of a replenishment object. The second connector assembly is located on the robotic arm and arranged to the first connector assembly abreast for mating with an outlet end of the replenishment object. The first pipeline set is connected to the first fluid tank and the first connector assembly. The second pipeline set is connected to the second fluid tank and the second connector assembly.

An embodiment of the present disclosure is to provide a fluid replenishing system. The fluid replenishing system includes a server equipment and a fluid replenishing autonomous mobile vehicle mentioned above. The server equipment includes a rack cabinet and a cooling distribution unit. The cooling distribution unit is provided with a case received within the rack cabinet. The cooling distribution unit includes a cooling channel, a fluid inlet and a fluid outlet. The fluid inlet and the fluid outlet are respectively arranged on one side of the case. The cooling channel is located within the case and connected to the fluid inlet and the fluid outlet. An interval distance between the first connector assembly and the second connector assembly is matched with an interval distance between the fluid inlet and the fluid outlet, such that the first connector assembly is able to be removably connected to the fluid inlet, and the second connector assembly is able to be removably connected to the fluid outlet.

An embodiment of the present disclosure is to provide a fluid replenishing method. The fluid replenishing method includes some steps as follows. A fluid replenishing autonomous mobile vehicle is dispatched to a cooling distribution unit of a server equipment. A first connector assembly and a second connector assembly of the fluid replenishing autonomous mobile vehicle are aligned with a fluid inlet and a fluid outlet of the cooling distribution unit, respectively. The first connector assembly to be mated with the fluid inlet and the second connector assembly to be mated with the fluid outlet are accomplished. Fluid in the cooling distribution unit is partially drawn out through the fluid outlet, the fluid from the cooling distribution unit is inspected and a determination is made as to whether the fluid from the cooling distribution unit is compliant. When the fluid drawn from the cooling distribution unit is determined to be compliant, new fluid is filled into the cooling distribution unit through the fluid inlet.

Thus, through the above architecture, the fluid replenishing system, the fluid replenishing autonomous mobile vehicle and the fluid replenishing method of the present disclosure herein can dynamically adjust the spacing between the first connector assembly and the second connector assembly thereof to be compatible with the fluid inlet and outlet of cooling distribution units with different specifications, thereby improving the service range of the fluid replenishing autonomous mobile vehicle and flexibility in cooperating with various server equipment.

The above is only used for describing the problem to be solved, the technical means to solve the problem, and the effect thereof and the like in the present disclosure, and the specific details of the present disclosure will be described in detail in the following implementations and related figures.

### BRIEF DESCRIPTION OF THE DRAWINGS

Fig. 1 is a perspective view of a fluid replenishing autonomous mobile vehicle according to one embodiment of the present disclosure.
Fig. 2A and Fig. 2B respectively are operational schematic views of an area M in Fig. 1.
Fig. 3 is a side view of a first connector assembly of Fig. 1.
Fig. 4 is an operational schematic view of a centering device of Fig. 3.
Fig. 5 is a longitudinal sectional view of a quick connector in Fig. 3.
Fig. 6 is a partial top view of the fluid replenishing autonomous mobile vehicle in Fig. 1.
Fig. 7 is a block diagram of a fluid replenishing system according to one embodiment of the present disclosure.
Fig. 8 is a perspective view of a server equipment of a fluid replenishing system of the embodiment.
Fig. 9 is an operational schematic view of the server equipment and the fluid replenishing autonomous mobile vehicle of the embodiment.
Fig. 10 is an operational schematic view of the fluid replenishing autonomous mobile vehicle and the docking station of the embodiment.
Fig. 11 is a flow chart of a fluid replenishing method according to one embodiment of the present disclosure.

### DETAILED DESCRIPTION

A plurality of embodiments of the present disclosure will be described below with reference to diagrams, and for the sake of clarity, many practical details will be described in the following description. However, it is to be understood that these practical details are not to be used for limiting the present disclosure. That is, in each embodiment of the present disclosure, these practical details are not necessary. In addition, for the sake of simplifying the diagrams, some of the conventional and commonly used structures and elements will be described in a simple schematic way in the diagrams.

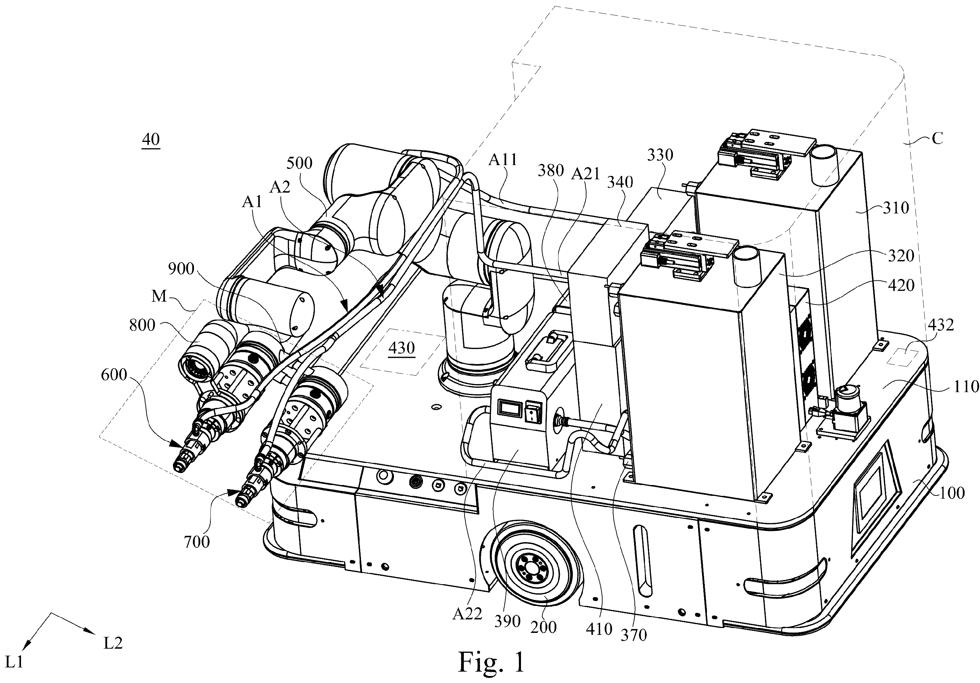

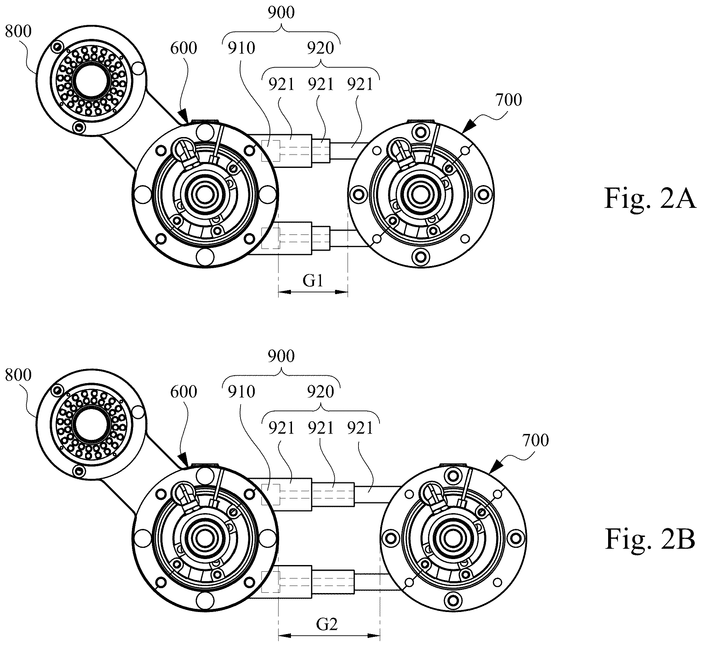

Fig. 1 is a perspective view of a fluid replenishing autonomous mobile vehicle 40 according to one embodiment of the present disclosure. Fig. 2A and Fig. 2B respectively are operational schematic views of an area M in Fig. 1. As shown in Fig. 1 to Fig. 2B, the fluid replenishing autonomous mobile vehicle 40 includes a working chassis 100, a moving mechanism 200, a first fluid tank 310, a second fluid tank 320, a robotic arm 500, a first connector assembly 600, a second connector assembly 700, a retractable member 900, a first pipeline set A1 and a second pipeline set A2. The moving mechanism 200 is located on the working chassis 100 and used to move to a designated position. The moving mechanism 200 is, for example, a drive motor and wheels etc., which are conventional technologies. The first fluid tank 310 is disposed on a placement surface 110 of the working chassis 100 and used to contain replenishing fluid (e.g., coolant). The second fluid tank 320 is disposed on the placement surface 110 of the working chassis 100 and used to contain recovered fluid (e.g., waste liquid). The robotic arm 500 is located on the placement surface 110 of the working chassis 100. The first connector assembly 600 is located on the robotic arm 500 and used to mate with an inlet end of a replenishment object (not shown in figures). The second connector assembly 700 is arranged side by side with the first connector assembly 600, and used to mate with an outlet end of the replenishment object (not shown in figures). The first pipeline set A1 is connected to the first fluid tank 310 and the first connector assembly 600. The second pipeline set A2 is connected to the second fluid tank 320 and the second connector assembly 700. The retractable member 900 is connected to the first connector assembly 600 and the second connector assembly 700, respectively, and the retractable member 900 is able to linearly push the second connector assembly 700 out or back in response to the relative position of the outlet end and the inlet end, so as to vary a spacing (or interval spacing G1) between the first connector assembly 600 and the second connector assembly 700 (Fig. 2A and Fig. 2B).

More specifically, the retractable member 900 includes a motive power device 910 and a telescopic sleeve 920. The telescopic sleeve 920 includes at least two sleeve units 921 which are slidably sleeved one another, and the same or different in size. The sleeve units 921 can be overlapped together to shorten the total length of the telescopic sleeve 920 (Fig. 2A), and conversely, the sleeve units 921 can be stretched to lengthen the total length of the telescopic sleeve 920 (Fig. 2B). The first of these sleeve units 921 is fixed on one side of the first connector assembly 600 facing towards the second connector assembly 700. The last one of these sleeve units 921 is fixed on one side of the second connector assembly 700 facing towards the first connector assembly 600. One end of the motive power device 910 is fixedly mounted on or inside the first connector assembly 600, and the other end is fixedly connected to one (e.g., the first one) of the sleeve units 921, so that the extension length of the telescopic sleeve 920 can be adjusted so as to move the second connector assembly 700 towards or away from the first connector assembly 600. The long axis direction L1 of the first connector assembly 600/the second connector assembly 700 is orthogonal to the long axis direction L2 of the telescopic sleeve 920 (Fig. 1).

In this embodiment, the motive power device 910 is, for example, a motor, a cylinder, a solenoid valve, etc. However, the present disclosure is not limited to the type of the motive power device 910.

Thus, when the motive power device 910 linearly pushes out the telescopic sleeve 920 by its moving part, the telescopic sleeve 920 pushes the second connector assembly 700 away from the first connector assembly 600 to increase the spacing G2 between the first connector assembly 600 and the second connector assembly 700 (Fig. 2B), or pulls the second connector assembly 700 closer to the first connector assembly 600 to reduce the spacing G1 between the first connector assembly 600 and the second connector assembly 700 (Fig. 2A). However, the present disclosure is not limited to the type of the retractable member 900.

However, the present disclosure is not limited thereto. In other embodiments, as long as the adjustment of the above-mentioned spacing can be implemented, the motive power device 910 may also be disposed on the second connector assembly 700; or/and, the position of the second connector assembly 700 may also be switched with the position of the first connector assembly 600, that is, the second connector assembly 700 may be mounted on the robotic arm 500.

In addition, the fluid replenishing autonomous mobile vehicle 40 further includes an image capturing device 800, a robotic arm controller 410 and a control device 420. The image capturing device 800 is disposed on the first connector assembly 600, and used to photograph the replenishment object to capture positioning images of the inlet end and the outlet end thereof. The robotic arm controller 410 is electrically connected to the robotic arm 500 and is used to control the robotic arm 500 to perform multi-axis motion. The control device 420 is mounted on the working chassis 100, arranged between the first fluid tank 310 and the second fluid tank 320, and electrically connected to the image capturing device 800, the robotic arm controller 410 and the retractable member 900. The control device 420 can instruct the robotic arm controller 410 to control the movements of the robotic arm 500, and the robotic arm controller 410 can also be integrated into the control device 420, so that the control device 420 can control the movements of the robot arm 500.

Thus, the control device 420 can analyze to obtain coordinate positions of the inlet end, the outlet end and the replenishment object shown in the positioning images, and the interval distance between the inlet end and the outlet end; then, control the robotic arm 500 to move the first connector assembly 600 and the second connector assembly 700 to close to the fluid inlet and fluid outlet, respectively according to the above information; and operate the retractable member 900 to adjust the spacing G1 between the first connector assembly 600 and the second connector assembly 700 so that the first connector assembly 600 is aligned with the inlet end, and the second connector assembly 700 is aligned with the outlet end, so that the first connector assembly 600 is physically mated with the inlet end and the second connector assembly 700 is physically mated with the outlet end.

However, the present disclosure is not limited thereto. In other embodiments, as long as the photography of the replenishment object is not hindered, the image capturing device 800 might also be disposed on either the robotic arm 500 or the second connector assembly 700.

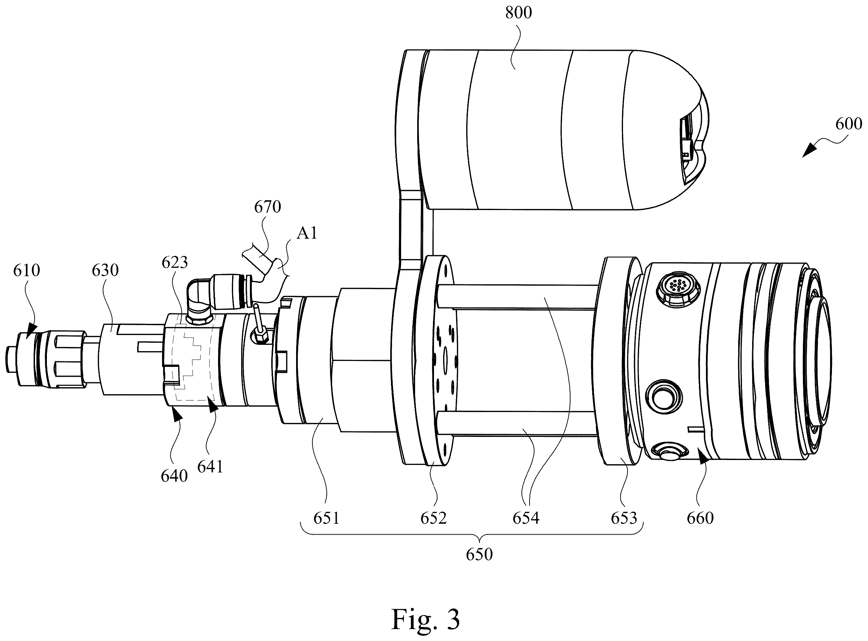

Fig. 3 is a side view of a first connector assembly 600 of Fig. 1. As shown in Fig.1 and Fig. 3, the first connector assembly 600 includes a quick connector 610, a buffering chamber 640 and a centering device 650. The quick connector 610 is disposed opposite to the robotic arm 500, and used to mate with the inlet end (not shown in figures). The buffering chamber 640 is sandwiched between the quick connector 610 and the centering device 650, and provided with a cavity space 641 therein, and the cavity space 641 is in communication with the first pipeline set A1 and the quick connector 610, respectively.

Also, the fluid replenishing autonomous mobile vehicle 40 further includes a pressure sensing device 660. The pressure sensing device 660 is connected to one side of the centering device 650 opposite to the quick connector 610, electrically connected to the control device 420, and used to sense pressure values of the quick connector 610 when being compressed. Thus, the control device 420 is able to control the robotic arm 500 to move the quick connector 610 of the first connector assembly 600 in response to the pressure value received by the pressure sensing device 660 to assist the connecting process between the first connector assembly 600 and the inlet end (not shown) of the replenishment object.

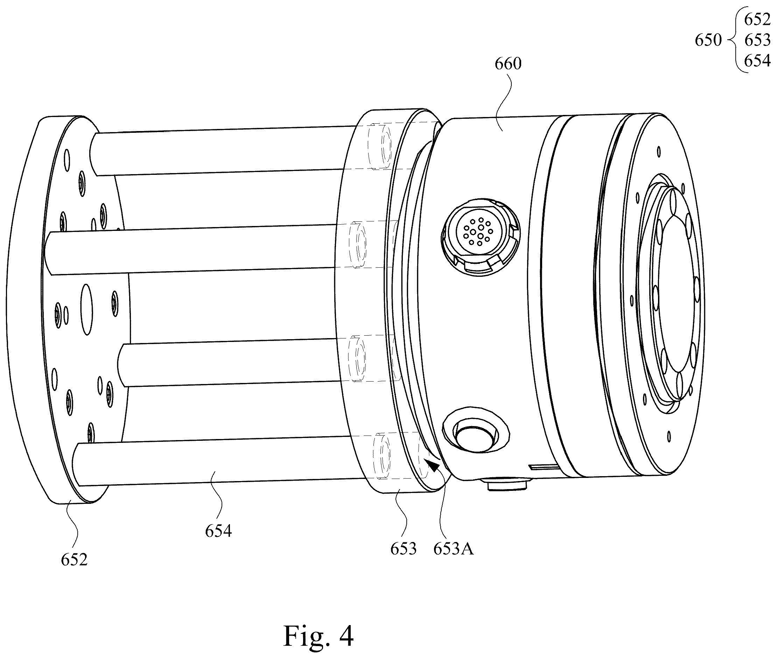

Fig. 4 is an operational schematic view of a centering device 650 of Fig. 3. As shown in Fig.3 and Fig. 4, the centering device 650 includes a main body 651, a first plate body 652, a second plate body 653 and a plurality (e.g., 4) of telescopic rods 654 spaced apart between the first plate body 652 and the second plate body 653. The main body 651 is sandwiched between the first plate body 652 and the buffering chamber 640, and fixedly fastened to the first plate body 652 and the buffering chamber 640. A front side of the second plate body 653 is faced towards the first plate body 652, and a rear side thereof is fixedly connected to the pressure sensing device 660. The second plate body 653 is formed with a plurality (e.g., 4) of through holes 653A equally spaced arranged on the front surface of the second plate body 653. More specifically, the front surface of the second plate body 653 is circular. These through holes 653A respectively represent different orientations (e.g., 3, 6, 9, and 12 o'clock positions) of the aforementioned front surface. These telescopic rods 654 are equidistantly distributed between the first plate body 652 and the second plate body 653. One end of each of the telescopic rods 654 is fixedly connected to the first plate body 652, and the other end is slidably received within one of the through holes 653A to abut against a portion of the pressure sensing device 660. Therefore, the pressure sensing device 660 can detect the pressure value of the first plate body 652 under pressure in one of specific orientations by sensing pressure amount of any one of the telescopic rods 654 being pressed.

Thus, the control device 420 can control the robotic arm 500 to move the quick connector 610 of the first connector assembly 600 according to the pressure value in different directions, so that the quick connector 610 of the first connector assembly 600 can be more unbiasedly connected to the inlet end (not shown) of the replenishment object.

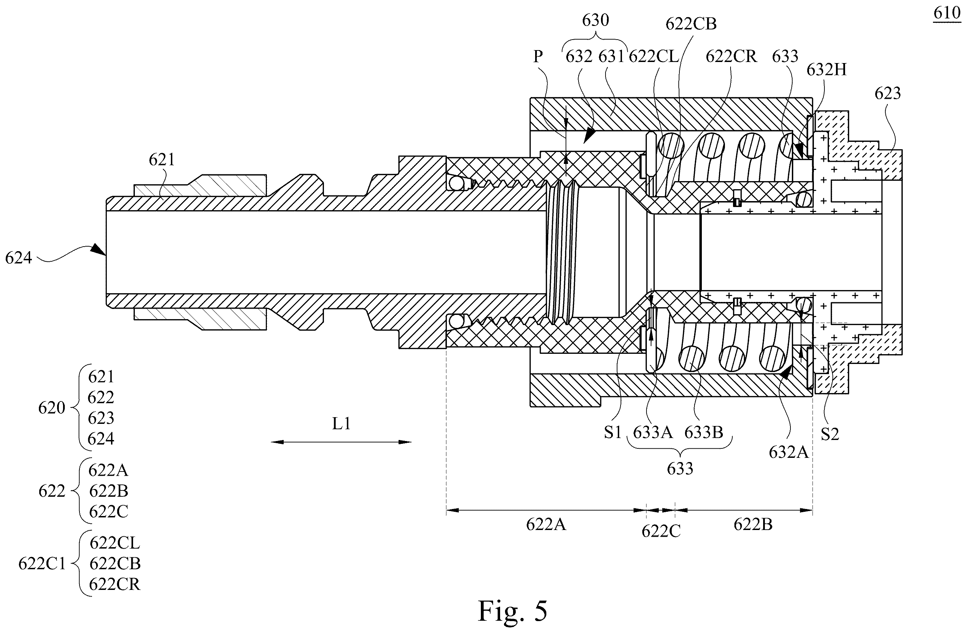

Fig. 5 is a longitudinal sectional view of a quick connector 610 in Fig. 3. As shown in Fig. 3 and Fig. 5, the quick connector 610 includes a joint unit 620, a sleeve unit 630 and a spring unit 633. The sleeve unit 630 includes a cylindrical body 631, a perforation 632H and a through groove 632. One end of the cylindrical body 631 is connected to one end of the buffering chamber 640. The through groove 632 is penetrated through the cylindrical body 631, and a long axis direction L1 of the through groove 632 is parallel to a long axis direction L1 of the quick connector 610. The perforation 632H penetrates through a bottom portion 632A of the through groove 632, and the diameter of the perforation 632H is smaller than the diameter of the through groove 632. The joint unit 620 partially extends into the through groove 632, the perforation 632H and the cavity space 641, and connected to the first pipeline set A1 (Fig. 3) through the cavity space 641. The spring unit 633 is received in the through groove 632, surrounds the joint unit 620 and respectively abuts against the joint unit 620 and the bottom portion 632A of the through groove 632.

The joint unit 620 which is in a straight tubular shape, includes a front section 621, an intermediate section 622, a rear section 623 and a straight channel 624. The intermediate section 622 is located between the front section 621 and the rear section 623, and connected to the front section 621 and the rear section 623. One portion of the intermediate section 622 extends into the through groove 632 and connected to the rear section 623 through the perforation 632H in the through groove 632, and another portion of the intermediate section 622 located outside the through groove 632, and used to connect to the front section 621. The front section 621 is used to mate the inlet end of the replenishment object (not shown in figures). A gap P is defined between the outer wall of the intermediate section 622 and the inner wall of the cylindrical body 631. The rear section 623 is located in the cavity space 641 of the buffering chamber 640. The straight channel 624 extends through the front section 621, the intermediate section 622, and the rear section 623 thereof, and in communication with the first pipeline set A1 through the cavity space 641(Fig. 3). The spring unit 633 includes an abutment ring 633A and a spring body 633B. The spring body 633B surrounds the intermediate section 622, and one end of the spring body 633B elastically abuts against the bottom portion 632A of the through groove 632, while the other end thereof is fixedly connected to the abutment ring 633A. One side of the abutment ring 633A opposite to the spring body 633B abuts against the intermediate section 622.

As shown in Fig. 5, the intermediate section 622 is divided into three regions, which are named as a left region 622A, a right region 622B and a middle region 622C connected to the left region 622A and the right region 622B, and the pipe diameters, from largest to smallest, are the left region 622A > right region 622B > middle region 622C. The abutment ring 633A is positioned at the middle region 622C, and the middle region 622C is provided with a grooved ring 622C1 in which an abutment ring 633A of the spring unit 633 is located. The grooved ring 622C1 is provided with a bottom portion 622CB, a first sidewall 622CL, and a second sidewall 622CR that is opposite to the first sidewall 622CL. The height of the first sidewall 622CL is greater than the height of the second sidewall 622CR. The first sidewall 622CL is connected to the left region 622A, and the second sidewall 622CR is connected to the right region 622B. The side of the abutment ring 633A opposite to the spring body 633B abuts against the first sidewall 622CL and a first buffer space S1 is defined between the abutment ring 633A and the bottom portion 622CB of the grooved ring 622C1, and a second buffer space S2 is defined between the right region 622B and the perforation 632H. Therefore, when the quick connector 610 is mated with the inlet end of the replenishment object to cause an alignment error therebetween, the alignment error can be corrected by moving the intermediate section 622 within the first buffer space S1 and the second buffer space S2. In details, when the alignment error (e.g., 3 mm) of the front section 621 of the quick connector 610 mated with the inlet end of the replenishment object is less than a movement value (e.g., 3.5 mm) of the intermediate section 622 in the first buffer space S1 and the second buffer space S2, the robotic arm 500 controls the quick connector 610 to continuously move towards the inlet end of the replenishment object, thereby automatically correcting the alignment error and completing the mating.

Thus, as shown in Fig. 1 and Fig. 5, when the robotic arm 500 attempts to mate the joint unit 620 of the first connector assembly 600 to the inlet end of the replenishment object (not shown), even if an error is caused between the joint unit 620 and the inlet end of the replenishment object, the joint unit 620 can be slightly offset within the through groove 632 through the linkage of the spring unit 633, thereby completing the mating between the joint unit 620 and the inlet end of the replenishment object.

In addition, the fluid replenishing autonomous mobile vehicle 40 further includes a hydraulic sensor 670. The hydraulic sensor 670 is located on the first pipeline set A1, electrically connected to the control device 420, and used to sense a hydraulic feedback value within the first pipeline set A1. Thus, when the first connector assembly 600 replenishes fluid to the replenishment object, the control device 420 detects that the hydraulic feedback value in the replenishment object has not reached to a preset standard through the hydraulic feedback value in the first pipeline set A1, it is indicated that the fluid in the replenishment object has not been fully replenished. In response to that, the control device 420 controls fluid replenished to the replenishment object with a replenish amount in response to the hydraulic feedback value. However, the disclosure is not limited thereto, and in other embodiments, the hydraulic sensor may be omitted.

It is noted that the first connector assembly 600 and the second connector assembly 700 in this embodiment are structurally the same or at least substantially the same. Therefore, the features of the second connector assembly 700 are described above and will not be repeated again.

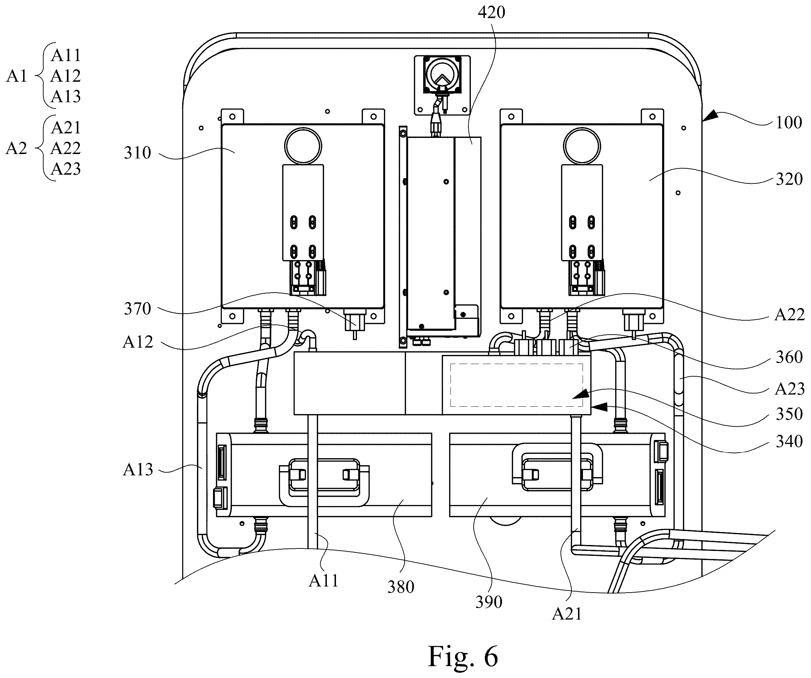

Fig. 6 is a partial top view of the fluid replenishing autonomous mobile vehicle 40 in Fig. 1. As shown in Fig. 1 and Fig. 6, the fluid replenishing autonomous mobile vehicle 40 further includes a first electric pump 380, a second electric pump 390, an inspection container 340 and a filter 330. The first electric pump 380, the second electric pump 390, the inspection container 340 and the filter 330 are respectively located on the placement surface 110 of the working chassis 100. The first electric pump 380 is able to pressurize the replenishing fluid in the first fluid tank 310 to replenish them into the filter 330. The second electric pump 390 is able to evacuate the second fluid tank 320 thereby allowing the second connector assembly 700 to recover the fluid from the replenishment object. The filter 330 is able to filter the fluid to the replenishment object. The inspection container 340 is formed with a fluid container 350 therein. The fluid container 350 can contain a small amount of fluid recovered from the replenishment object. In addition, the first fluid tank 310 and the second fluid tank 320 are further provided with a level gauge 370 (Fig. 1) to determine a liquid level height in the first fluid tank 310 and the second fluid tank 320.

Furthermore, in this embodiment, the robotic arm controller 410 is located between the first electric pump 380 and the first fluid tank 310, and between the second electric pump 390 and the second fluid tank 320. The filter 330 and the inspection container 340 are placed on the robotic arm controller 410; however, the disclosure is not limited thereto.

A front pipeline A11 (e.g., soft hose) of a first pipeline set A1 is in communication with the filter 330 and the first connector assembly 600, respectively. A first rear pipeline A12 (e.g., soft hose) of the first pipeline set A1 is in communication with the filter 330 and the first fluid tank 310, respectively. A second rear pipeline A13 (e.g., soft hose) of the first pipeline set A1 is in communication with the first electric pump 380 and the first fluid tank 310, respectively. A front pipeline A21 (e.g., soft hose) of a second pipeline set A2 is in communication with the fluid container 350 and the second connector assembly 700, respectively. A first rear pipeline A22 (e.g., soft hose) of the second pipeline set A2 is in communication with the second electric pump 390 and the second fluid tank 320, respectively. A second rear pipeline A23 (e.g., soft hose) of the second pipeline set A2 is in communication with the fluid container 350 and the second fluid tank 320, respectively.

The control device 420 is electrically connected to the first electric pump 380 and the second electric pump 390, and used to control the first electric pump 380 to perform fluid replenishment operation on the replenishment object in response to the hydraulic feedback value of the hydraulic sensor 670, and to control the second electric pump 390 to draw fluid out from the replenishment object.

Furthermore, the inspection container 340 is equipped with a plurality of fluid quality inspection units 360 respectively located on the fluid container 350 and connected to the fluid container 350 for inspecting the fluid in the fluid container 350. For example, these fluid quality inspection units 360 may be copper ion meters, pH meters, and turbidity meters, etc. However, the present disclosure is not limited thereto.

Finally, for protection purposes, an outer cover C can be placed on the placement surface 110 of the working chassis 100 so that the first fluid tank 310, the second fluid tank 320, the control device 420, the robotic arm controller 410, the filter 330, the inspection container 340, the fluid quality inspection units 360, the first electric pump 380 and the second electric pump 390 can be contained therein.

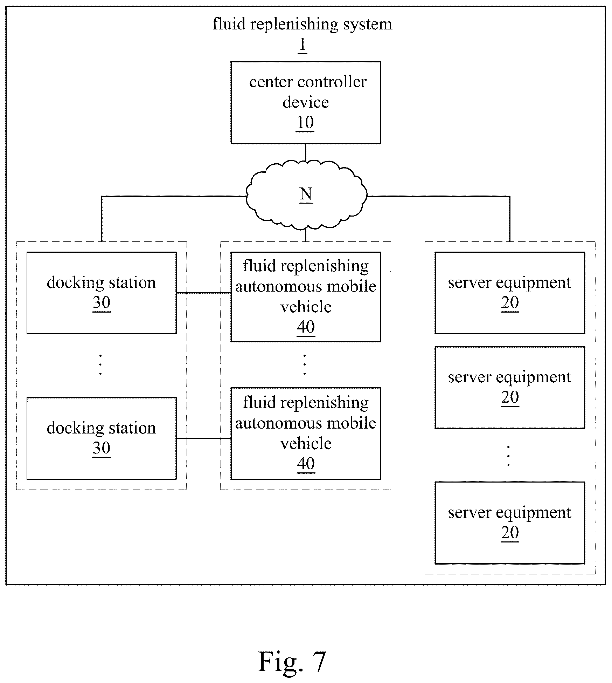

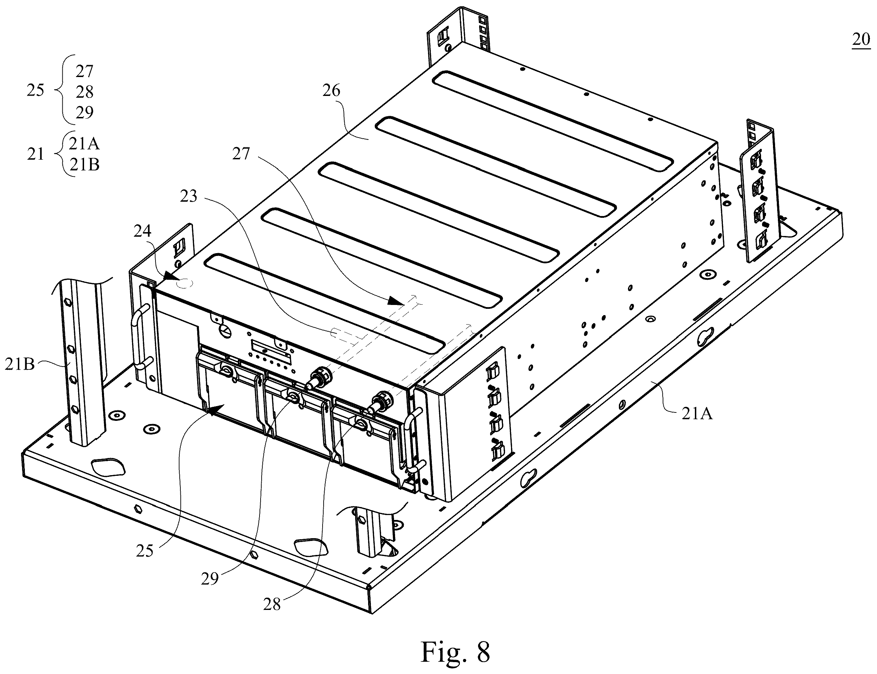

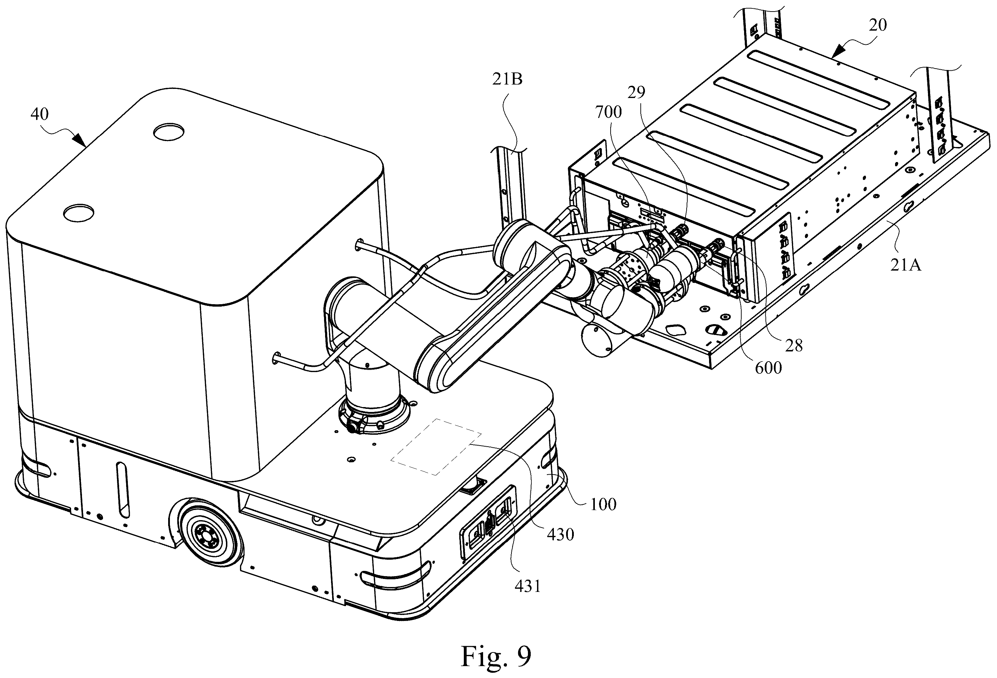

Fig. 7 is a block diagram of a fluid replenishing system 1 according to one embodiment of the present disclosure. Fig. 8 is a perspective view of a server equipment of a fluid replenishing system 1 of the embodiment. Fig. 9 is an operational schematic view of the server equipment 20 and the fluid replenishing autonomous mobile vehicle 40 of the embodiment.

As shown in Fig. 7 to Fig. 9, the fluid replenishing system 1 includes a center controller device 10, a plurality of server equipment 20, a plurality of docking stations 30 and a plurality of fluid replenishing autonomous mobile vehicles 40. Each of these server equipment 20 includes a rack cabinet 21 and at least one cooling distribution unit 25. For example, the rack cabinet 21 is a combination of a base plate 21A and a side column 21B. The cooling distribution unit 25 is provided with a case 26, a cooling channel 27, a fluid inlet 28 and a fluid outlet 29. The case 26 is received within the rack cabinet 21. The fluid inlet 28 and the fluid outlet 29 are respectively arranged on one side of the case 26. The cooling channel 27 is located within the case 26 and connected to the fluid inlet 28 and the fluid outlet 29. The cooling channel 27 can be for example, a pipeline, a water tank, or a heat exchange chamber, etc.

Also, each of the server equipment 20 further includes a hydraulic sensing unit 23 located within the cooling channel 27 for sensing a hydraulic feedback value within the cooling channel 27. Thus, when the cooling distribution unit 25 determines that the hydraulic feedback value has not reached a preset standard, the cooling distribution unit 25 sends a fluid replenishment notification to the center controller device 10.

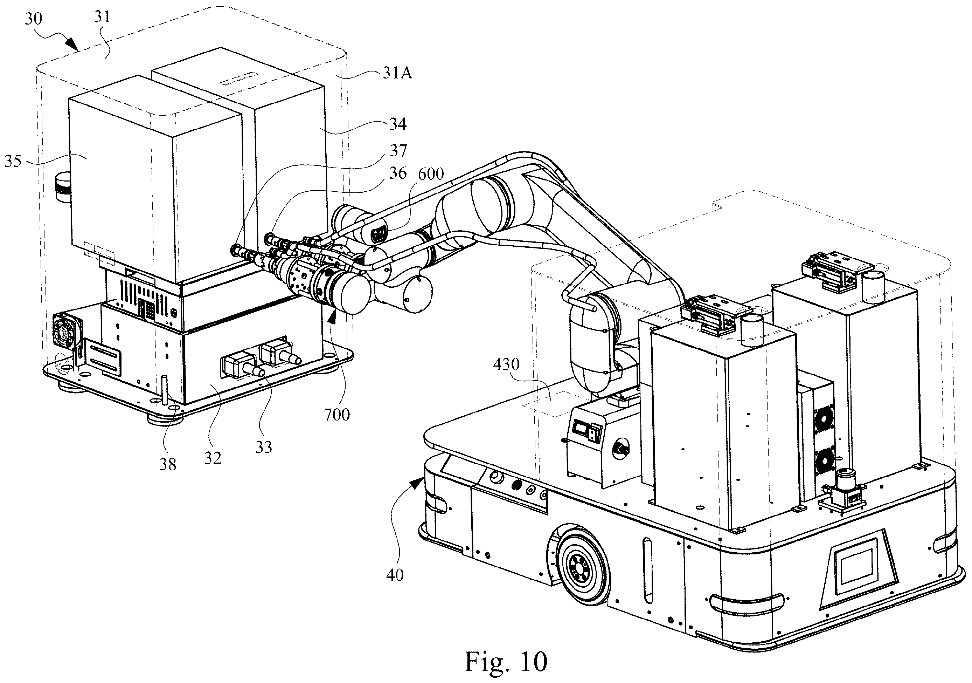

Fig. 10 is an operational schematic view of the fluid replenishing autonomous mobile vehicle 40 and the docking station 30 of the embodiment. As shown in Fig. 7 and Fig. 10, each of the docking stations 30 can provide one of the fluid replenishing autonomous mobile vehicles 40 to be parked and charged aside. More specifically, each docking station 30 includes a housing 31 and a charging module 32 located inside the housing 31. The housing 31 is provided with a docking surface 31A. The charging module 32 is provided with a plurality of power supply contacts 33 which are exposed outwards from the docking surface 31A.

As shown in Fig. 9 to Fig. 10, the fluid replenishing autonomous mobile vehicle 40 further includes a battery module 430 and one or more (e.g., 2) charging contacts 431. The battery module 430 is mounted inside the working chassis 100, and the charging contacts 431 are exposed from the working chassis 100 and removably connected to the power supply contacts 33. Thus, when the fluid replenishing autonomous mobile vehicle 40 docks to the docking surface 31A of the docking station 30, so that the charging contacts 431 of the fluid replenishing autonomous mobile vehicle 40 are removably and electrically connected to the power supply contacts 33 of the docking station 30, thereby allowing the charging module 32 to charge the battery module 430.

Furthermore, as shown in Fig. 10, each of the docking stations 30 allows the fluid replenishing autonomous mobile vehicle 40 to exchange coolant. More specifically, the docking station 30 further includes a replenishment tank 34, a waste fluid tank 35, a drain fitting 36 and a supply fitting 37. The replenishment tank 34 is located inside the housing 31 and used to contain replenishing fluid (e.g., coolant). The waste fluid tank 35 is located inside the housing 31 and used to contain the recovered fluid (e.g., waste liquid) recovered by the fluid replenishing autonomous mobile vehicle 40. The drain fitting 36 is located on the docking surface 31A and in communication with the replenishment tank 34. The supply fitting 37 is located alongside the drain fitting 36 and in communication with the waste fluid tank 35. Both of the replenishment tank 34 and the waste fluid tank 35 are equipped with level gauges (not shown in figures) that are able to reflect their liquid levels. Thus, when the fluid replenishing autonomous mobile vehicle 40 moves to the docking station 30, the fluid replenishing autonomous mobile vehicle 40 may also choose to use the first connector assembly 600 to be mated with the drain fitting 36 to receive fluid from the docking station 30, and use the second connector assembly 700 to be mated with the supply fitting 37 to drain fluid into the docking station 30. More specifically, the fluid in the replenishment tank 34 will be added to the first fluid tank 310 through the mating of the drain fitting 36 and the first connector assembly 600. The waste liquid in the second fluid tank 320 will be drained to the waste fluid tank 35 through the mating of the supply fitting 37 and the second connector assembly 700.

As shown in Fig. 7 to Fig. 9, the center controller device 10 is electrically connected to the fluid replenishing autonomous mobile vehicles 40, the docking stations 30, and the server equipment 20 via network architecture N. The center controller device 10 is used to receive feedback signals (e.g., replenishment notifications or hydraulic feedback values of the hydraulic sensing unit 23) from any server equipment 20, detect positions, task progresses and idle status of the fluid replenishing autonomous mobile vehicles 40, send control signals (e.g., dispatching commands) to the fluid replenishing autonomous mobile vehicles 40, and monitor the liquid level in the replenishment tank 34 and the waste fluid tank 35 of the docking stations 30.

For example, when the center controller device 10 receives a fluid replenishment notification from one of the server equipment 20, the center controller device 10 (1) dispatches one of the fluid replenishing autonomous mobile vehicles 40 to perform fluid replenishment on the cooling distribution unit 25 of the server equipment 20, (2) provides a suitable movement route so that the fluid replenishing autonomous mobile vehicle 40 can move to the server equipment 20 in time, and (3) in response to the above-mentioned hydraulic feedback value, instructs the fluid replenishing autonomous mobile vehicle 40 to replenish the cooling distribution unit 25 according to the corresponding replenishment amount.

Before the fluid replenishing autonomous mobile vehicle 40, which has reached the server equipment 20, performs the fluid replenishment, the fluid replenishing autonomous mobile vehicle 40 can detect the position and distance between the fluid inlet 28 and the fluid outlet 29 through the feedback images from the image capturing device 800, and correspondingly control the extension length of the retractable member 900 so that an interval distance between the first connector assembly 600 and the second connector assembly 700 is matched (e.g., equal or approximately equal) with an interval distance between the fluid inlet 28 and the fluid outlet 29. At the same time, the fluid replenishing autonomous mobile vehicle 40 controls the movement of the robotic arm 500 such that the first connector assembly 600 is able to be removably connected to the fluid inlet 28, and the second connector assembly 700 is able to be removably connected to the fluid outlet 29.

During the initial mating moment, based on the pressure value fed back by the pressure sensing device 660, the fluid replenishing autonomous mobile vehicle 40 determines whether the first connector assembly 600 and the fluid inlet 28 are properly mated, and the second connector assembly 700 and the fluid outlet 29 are properly mated. If not, the robotic arm 500 and/or the retractable member 900 are controlled to move towards the proper position based on the pressure value fed back by the pressure sensing device 660.

Next, a small amount of coolant from the cooling distribution unit 25 (referred to recovered coolant hereinafter) is recovered, and the recovered coolant is tested to determine whether the content (e.g., pH value, copper ion content, turbidity, etc.) thereof is compliant. After the recovered coolant from the cooling distribution unit 25 is found to be compliant, the fluid replenishing autonomous mobile vehicle 40 will only replenish the cooling distribution unit 25 according to the above-mentioned replenishment amount, and will not completely draw out the recovered coolant; otherwise, completely drawing out the recovered coolant and fully filling with new coolant into the cooling distribution unit 25 can be performed simultaneously.

Finally, after completing its mission, the fluid replenishing autonomous mobile vehicle 40 returns to its docking station 30 so as to perform charging and fluid exchange operations.

More specifically, in Fig. 1 and Fig. 8, each of the server equipment 20 further includes a first signal transmitter 24 disposed on the cooling distribution unit 25 for intermittently emitting a first position signal. Each of the docking stations 30 further includes a second signal transmitter 38 disposed on the housing 31 for intermittently emitting a second position signal. The fluid replenishing autonomous mobile vehicle 40 further includes a signal receiver 432 disposed on the working chassis 100 for receiving a first position signal to reach the corresponding server equipment 20, or a second position signal to reach the corresponding docking station 30. Thus, by sensing the aforementioned second position signal through the signal receiver 432, the fluid replenishing autonomous mobile vehicle 40 can dock at the docking surface 31A of the docking station 30 to perform the aforementioned charging and fluid exchange operations.

It is noted, in this embodiment, the quick connector 610 of the first connector assembly 600 and the fluid inlet 28 of the server equipment 20 are structurally complementary, for example, the complementary design of male and female connectors. Similarly, the quick connector 610 of the second connector assembly 700 and the fluid outlet 29 of the server equipment 20 are also structurally complementary, for example, the complementary design of male and female connectors. In addition, each of the fluid replenishing autonomous mobile vehicles 40 in this embodiment is the same as the fluid replenishing autonomous mobile vehicle 40 in the above embodiments. Therefore, the features of the fluid replenishing autonomous mobile vehicle 40 are described above and will not be repeated again.

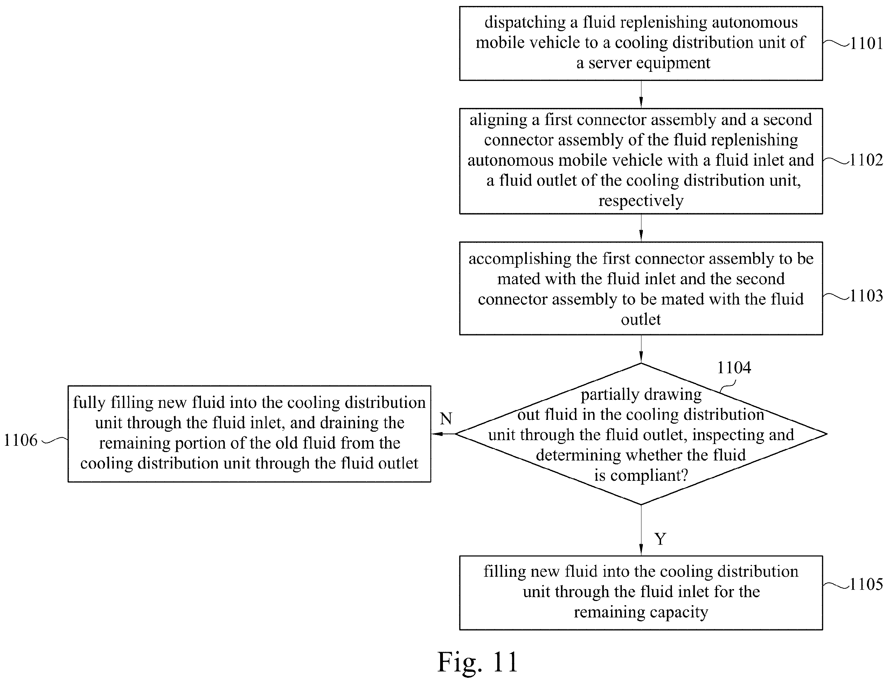

Fig. 11 is a flow chart of a fluid replenishing method according to one embodiment of the present disclosure. As shown in Fig. 11, the fluid replenishing method in the embodiment includes step 1101 to step 1106 as follows. In step 1101, a fluid replenishing autonomous mobile vehicle is dispatched to a cooling distribution unit of a server equipment. In step 1102, a first connector assembly and a second connector assembly of the fluid replenishing autonomous mobile vehicle are aligned with a fluid inlet and a fluid outlet of the cooling distribution unit, respectively. In step 1103, the first connector assembly to be mated with the fluid inlet and the second connector assembly to be mated with the fluid outlet are accomplished. In step 1104, fluid in the cooling distribution unit is partially drawn out through the fluid outlet, the drawn fluid from the cooling distribution unit is inspected and a determination is made as to whether the fluid from the cooling distribution unit is compliant. If yes, go step 1105, otherwise go step 1106. In step 1105, the remaining capacity of the new fluid is filled into the cooling distribution unit through the fluid inlet. In step 1106, new fluid is fully filled into the cooling distribution unit through the fluid inlet, and the remaining portion of the old fluid is drained from the cooling distribution unit through the fluid outlet.

Furthermore, the step 1101 further includes the following detailed steps. A determination is made as to whether a hydraulic pressure value detected within the cooling distribution unit has not met a preset standard. Only if the hydraulic pressure value is not met the preset standard, the fluid replenishing autonomous mobile vehicle is then dispatched to the cooling distribution unit.

The step 1102 further includes the following detailed steps. The cooling distribution unit is photographed so as to capture positioning images of the fluid inlet and the fluid outlet of the cooling distribution unit; next, the spacing between the first connector assembly and the second connector assembly is adjusted in response to the positioning images of the fluid inlet and the fluid outlet so that the first connector assembly is coaxially aligned with the fluid inlet, and the second connector assembly is coaxially aligned with the fluid outlet. More specifically, the first connector assembly and the second connector assembly can be moved by the robotic arm to confront with the fluid inlet and fluid outlet of the cooling distribution unit. Then, the spacing between the first connector assembly and the second connector assembly is adjusted by varying the length of the retractable member 900 between the first connector assembly and the second connector assembly, thereby achieving the coaxial alignment of the first connector assembly with the fluid inlet, and the coaxial alignment of the second connector assembly with the fluid outlet.

The step 1103 further includes the following detailed steps. The pressure values of the first connector assembly and the second connector assembly being compressed are sensed. When the pressure values meet the preset standards, it is determined that the first connector assembly is properly mated with the fluid inlet and the second connector assembly is properly mated with the fluid outlet. Otherwise, orientation adjustment is achieved through the robotic arm and/or retractable member of the fluid replenishing autonomous mobile vehicle until the pressure values of the first connector assembly and second connector assembly meet the preset standards.

The step 1104 further includes the following detailed step. The fluid is tested for copper ions, pH and turbidity so as to be determined whether the fluid is compliant or satisfied quality standards.

In the step 1105, since the fluid in the cooling distribution unit is compliant, the fluid replenishing autonomous mobile vehicle is only needed to fill the remaining capacity of the new fluid into the cooling distribution unit. Thus, the step 1105 further includes the following detailed steps. The fluid replenishing autonomous mobile vehicle determines whether the hydraulic pressure of the new fluid in the cooling distribution unit meets a preset standard. If so, the fluid replenishing autonomous mobile vehicle stops filling new fluid into the cooling distribution unit, otherwise, it continues to fill new fluid until the hydraulic pressure of the new fluid meets the preset standard. Next, the first connector assembly is disconnected from the fluid inlet and the second connector assembly is disconnected from the fluid outlet, respectively.

More specifically, the hydraulic sensing unit in the cooling distribution unit senses the hydraulic feedback value in the cooling channel, feeds it back to the fluid replenishing autonomous mobile vehicle, and determines whether to continue or stop filling new fluid into the cooling distribution unit based on the hydraulic feedback value in the cooling distribution unit. Alternatively, the fluid replenishing autonomous mobile vehicle determines whether to continue or stop filling new fluid into the cooling distribution unit based on the hydraulic feedback value sensed by the hydraulic sensor in the first pipeline set connected to the first connector assembly.

In the step 1106, since the fluid in the cooling distribution unit is incompliant, the fluid replenishing autonomous mobile vehicle needs to overly fill new fluid into the cooling distribution unit until the remaining portion of the old fluid in the cooling distribution unit is totally replaced and drained; then, the drained fluid is inspected. If the inspected fluid is compliant, the first connector assembly is disconnected from the fluid inlet and the second connector assembly is disconnected from the fluid outlet. Otherwise, new fluid is kept filling until the fluid is inspected to be compliant.

Thus, through the above architecture, the fluid replenishing system, the fluid replenishing autonomous mobile vehicle and the fluid replenishing method of the present disclosure herein can dynamically adjust the spacing between the first connector assembly and the second connector assembly thereof to be compatible with the fluid inlet and outlet of cooling distribution units with different specifications, thereby improving the service range of the fluid replenishing autonomous mobile vehicle and flexibility in cooperating with various server equipment.

## Claims

1. A fluid replenishing autonomous mobile vehicle (40), comprising:
a working chassis (100);
a moving mechanism (200) located on the working chassis (100) for moving to a designated position;
a first fluid tank (310) located on the working chassis (100) for containing replenishing fluid;
a second fluid tank (320) located on the working chassis (100) for containing recovered fluid;
a robotic arm (500) located on the working chassis (100);
a first connector assembly (600) located on the robotic arm (500) for mating with an inlet end of a replenishment object;
a second connector assembly (700) located on the robotic arm (500) and arranged to the first connector assembly (600) abreast for mating with an outlet end of the replenishment object;
a first pipeline set (A1) connected to the first fluid tank (310) and the first connector assembly (600); and
a second pipeline set (A2) connected to the second fluid tank (320) and the second connector assembly (700).

2. The fluid replenishing autonomous mobile vehicle (40) according to claim 1, further comprising:
a retractable member (900) respectively connected to the first connector assembly (600) and the second connector assembly (700) for varying a spacing between the first connector assembly (600) and the second connector assembly (700).

3. The fluid replenishing autonomous mobile vehicle (40) according to claim 1, wherein the first connector assembly (600) comprises:
a centering device(650);
a quick connector (610) for mating with the inlet end; and
a buffering chamber (640) sandwiched between the quick connector (610) and the centering device(650), and provided with a cavity space (641) in communication with the first pipeline set (A1) and the quick connector (610), respectively.

4. The fluid replenishing autonomous mobile vehicle (40) according to claim 3, further comprising:
a pressure sensing device (660) connected to one side of the centering device (650) opposite to the quick connector (610) for sensing a pressure value of the quick connector (610) being compressed; and
a control device (420) located on the working chassis (100), electrically connected to the pressure sensing device (660) for moving the quick connector (610) by the robotic arm (500) in response to the pressure value.

5. The fluid replenishing autonomous mobile vehicle (40) according to claim 4, wherein the centering device(650) comprises:
a first plate body (652);
a second plate body (653) fixedly connected to the pressure sensing device (660) and formed with a plurality of through holes (653A) equally spaced arranged on one surface of the second plate body (653) facing towards the first plate body (652); and
a plurality of telescopic rods (654) spaced apart between the first plate body (652) and the second plate body (653), and each of the telescopic rods (654) that is slidably received within one of the through holes (653A) to abut against the pressure sensing device (660),
wherein the pressure sensing device (660) detects the pressure value of the first plate body (652) under pressure in one of specific orientations by sensing pressure amount of any one of the telescopic rods (654) being pressed.

6. The fluid replenishing autonomous mobile vehicle (40) according to claim 3, wherein the quick connector (610) comprises:
a sleeve unit (921) comprising a cylindrical body (631) that is connected to one end of the buffering chamber (640), a through groove (632) that is formed on the cylindrical body (631), and a perforation (632H) that penetrates through a bottom portion (632A) of the through groove (632);
a joint unit (620) located within the through groove (632) and the cavity space (641) of the buffering chamber (640), and connected to the first pipeline set (A1) through the cavity space (641); and
a spring unit (633) received in the through groove (632), surrounding the joint unit (620) and respectively abutting against the joint unit (620) and the bottom portion (632A) of the through groove (632).

7. The fluid replenishing autonomous mobile vehicle (40) according to claim 6, wherein the joint unit (620) comprises a front section (621), an intermediate section (622), a rear section (623) and a straight channel (624), the intermediate section (622) is connected to the front section (621) and the rear section (623), one portion of the intermediate section (622) is extended into the through groove (632) and connected to the rear section (623) through the perforation (632H) in the through groove (632), and another portion of the intermediate section (622) is located outside the through groove (632), and used to connect to the front section (621), and the straight channel (624) extends through the front section (621), the intermediate section (622), and the rear section (623).

8. The fluid replenishing autonomous mobile vehicle (40) according to claim 7, wherein the intermediate section (622) is divided into a left region (622A), a right region (622B) and a middle region (622C), the middle region (622C) is connected to the left region (622A) and the right region (622B) and provided with a grooved ring (622C1) in which an abutment ring (633A) of the spring unit (633) is located, a first buffer space (S1) is defined between the abutment ring (633A) and a bottom portion (632A) of the grooved ring (622C1), and a second buffer space (S2) is defined between the right region (622B) and the perforation (632H).

9. The fluid replenishing autonomous mobile vehicle (40) according to claim 1, further comprises:
an electric pump (380) located on the working chassis (100) and connected to the first fluid tank (310) through the first pipeline set (A1);
a hydraulic sensor (670) located on the first pipeline set (A1) for sensing a hydraulic feedback value within the first pipeline set (A1); and
a control device (420) located on the working chassis (100), electrically connected to the electric pump (380) and the hydraulic sensor (670) for controlling the electric pump (380) to replenish fluid to the replenishment object in response to the hydraulic feedback value.

10. The fluid replenishing autonomous mobile vehicle (40) according to claim 1, further comprises:
an inspection container (340) located on the working chassis (100) and formed with a fluid container (350) therein, wherein the fluid container (350) contains fluid recovered from the replenishment object, a front pipeline (A11) of a second pipeline set (A2) is connected to the fluid container (350) and the second connector assembly (700), respectively, and a rear pipeline (A12) of the second pipeline set (A2) is connected to the fluid container (350) and the second fluid tank (320) respectively; and
a plurality of fluid quality inspection units (360) respectively located on the inspection container (340) and connected to the fluid container (350) for inspecting the fluid in the fluid container (350).

11. The fluid replenishing autonomous mobile vehicle (40) according to claim 2, wherein the retractable member (900) comprises:
a motive power device (910) mounted on the first connector assembly (600); and
a telescopic sleeve (920) respectively connected to the motive power device (910), the first connector assembly (600) and the second connector assembly (700) for moving the second connector assembly (700) towards and away from the first connector assembly (600).

12. A fluid replenishing system (1), comprising:
a server equipment (20) comprising a rack cabinet (21) and a cooling distribution unit (25), the cooling distribution unit (25) that is provided with a case (26) received within the rack cabinet (21), the cooling distribution unit (25) comprising a cooling channel (27), a fluid inlet (28) and a fluid outlet (29), the fluid inlet (28) and the fluid outlet (29) which are respectively arranged on one side of the case (26), the cooling channel (27) that is located within the case (26) and connected to the fluid inlet (28) and the fluid outlet (29); and
a fluid replenishing autonomous mobile vehicle (40) according to one of claims 1-11,
wherein an interval distance between the first connector assembly (600) and the second connector assembly (700) is matched with an interval distance between the fluid inlet (28) and the fluid outlet (29), such that the first connector assembly (600) is able to be removably connected to the fluid inlet (28), and the second connector assembly (700) is able to be removably connected to the fluid outlet (29).

13. The fluid replenishing system (1) according to claim 12, further comprises:
a docking station (30) comprising a housing (31) having a docking surface (31A), and a charging module (32) located inside the housing (31) and provided with a power supply contact (33) exposed outwards from the docking surface (31A); and
the fluid replenishing autonomous mobile vehicle (40) further comprising a battery module (430) located inside the working chassis (100), and the battery module (430) that is provided with a charging contact (431) exposed from the working chassis (100) and removably connected to the power supply contact (33).

14. The fluid replenishing system (1) according to claim 12, wherein the docking station (30) further comprises:
a replenishment tank (34) located inside the housing (31);
a waste fluid tank (35) located inside the housing (31);
a drain fitting (36) located on the docking surface (31A) and in communication with the replenishment tank, wherein the fluid replenishing autonomous mobile vehicle (40) uses the first connector assembly (600) to be mated with the drain fitting (36) to receive fluid from the docking station (30); and
a supply fitting (37) located alongside the drain fitting (36) and in communication with the waste fluid tank (35), wherein the fluid replenishing autonomous mobile vehicle (40) uses the second connector assembly (700) to be mated with the supply fitting (37) to drain fluid into the docking station (30).

15. The fluid replenishing system (1) according to claim 12, wherein the server equipment (20) further comprises a hydraulic sensing unit (23) located within the cooling channel (27) for sensing a hydraulic feedback value within the cooling channel (27),
when the hydraulic feedback value is insufficient, the center controller device (10) dispatches the fluid replenishing autonomous mobile vehicle (40) to replenish the cooling distribution unit (25) with a replenish amount in response to the hydraulic feedback value.

16. A fluid replenishing method, comprising:
dispatching a fluid replenishing autonomous mobile vehicle (40) to reach a cooling distribution unit (25) of a server equipment (20);
aligning a first connector assembly (600) and a second connector assembly (700) of the fluid replenishing autonomous mobile vehicle (40) with a fluid inlet (28) and a fluid outlet (29) of the cooling distribution unit (25), respectively;
accomplishing the first connector assembly (600) to be mated with the fluid inlet (28) and the second connector assembly (700) to be mated with the fluid outlet (29);
partially drawing out fluid in the cooling distribution unit (25) through the fluid outlet (29), inspecting and determining whether the fluid drawn from the cooling distribution unit (25) is compliant; and
when the fluid drawn from the cooling distribution unit (25) is determined to be compliant, filling new fluid into the cooling distribution unit (25) through the fluid inlet (28).

17. The fluid replenishing method according to claim 16, wherein when the fluid from the cooling distribution unit (25) is determined to be incompliant, fully filling new fluid into the cooling distribution unit (25) through the fluid inlet (28), and drawing out a remaining portion of the fluid in the cooling distribution unit (25) through the fluid outlet (29).

18. The fluid replenishing method according to claim 17, wherein the step of fully filling new fluid into the cooling distribution unit (25) through the fluid inlet (28), further comprises:
determining whether a hydraulic pressure value of the new fluid in the cooling distribution unit (25) meets a preset standard;
when the hydraulic pressure value of the new fluid is determined to meet the preset standard, stopping filling the new fluid into the cooling distribution unit (25); and
disconnecting the first connector assembly (600) from the fluid inlet (28) and the second connector assembly (700) from the fluid outlet (29), respectively.
